# EUROPÄISCHE PATENTANMELDUNG

(11) **EP 1 772 737 A2**
(43) Veröffentlichungstag der Anmeldung: **11.04.2007**
(21) Anmeldenummer: 06121590.1
(22) Anmeldetag: 02.10.2006
(51) Int. Cl.: G01R 15/20

(54) **Baugruppe zur Strommessung**

(30) Priorität: 08.10.2005 CH 16392005
(71) Anmelder: SENTRON AG, 6300 Zug (CH)
(72) Erfinder: Racz, Robert, 6300 Zug (CH); Huber, Samuel, 8004 Zuerich (CH)
(74) Vertreter: Falk, Urs

(57) **Zusammenfassung**

Eine Baugruppe zur Strommessung umfasst ein Leiterblech (1) mit drei Ausnehmungen (5, 6, 7) und ein auf dem Leiterblech (1) platziertes Messelement, das einen aus zwei Magnetfeldsensoren (2, 3) gebildeten Differenzsensor (4) aufweist. Durch die drei Ausnehmungen (5, 6, 7) sind im Leiterblech (1) ein erster und ein zweiter Leiterabschnitt (8, 9) gebildet, wobei die Stromrichtung im zweiten Leiterabschnitt (9) entgegengesetzt zur Stromrichtung im ersten Leiterabschnitt (8) verläuft. Der erste Magnetfeldsensor (2) befindet sich oberhalb des ersten Leiterabschnitts (8) und der zweite Magnetfeldsensor (3) befindet sich oberhalb des zweiten Leiterabschnitts (9). Die Magnetfeldsensoren (2, 3) sind empfindlich auf ein Magnetfeld, das parallel zur Oberfläche des Leiterblechs (1) und orthogonal zur Stromrichtung in den beiden Leiterabschnitten (8, 9) verläuft.

## Beschreibung

Die Erfindung betrifft eine Baugruppe zur Strommessung.

Die berührungslose Strommessung mit Hallelementen kommt bei vielen Anwendungen zum Einsatz, beispielsweise in Elektrizitätszählern oder für die Messung des einer Batterie zugeführten oder entnommenen Stroms. Das Hallelement misst das vom Strom erzeugte Magnetfeld. Um den Einfluss von magnetischen Störfeldern, die von anderen Magnetfeldquellen herrühren, zu reduzieren, werden vielfach Abschirmungen aus ferromagnetischem Material eingesetzt. Da solche Abschirmungen aber oft zu wenig wirksam sind und eine Verbesserung der Abschirmung schwierig und wenn überhaupt nur mit hohem Aufwand möglich ist, wurden Vorrichtungen mit einem u-förmigen oder s-förmigen Leiter und zwei Hallelementen entwickelt, wobei das vom Strom erzeugte Magnetfeld an den Orten der beiden Hallelemente in zueinander entgegengesetzte Richtungen zeigt. Der Strom erzeugt deshalb in den beiden Hallelementen Hallspannungen mit entgegengesetztem Vorzeichen, während ein äusseres Störfeld Hallspannungen mit dem gleichen Vorzeichen erzeugt. Derartige Vorrichtungen sind aus der WO 99/60416 und der WO 01/23899 bekannt. Weil die Hallelemente innerhalb der Ausnehmungen des u-förmigen bzw. s-förmigen Leiters platziert werden müssen, ist es nicht möglich, die beiden Hallelemente auf einem einzigen Halbleiterchip zu integrieren. Auch der Zusammenbau der verschiedenen Komponenten ist deswegen aufwendig und kompliziert. Zudem ist die Empfindlichkeit relativ gering.

Der Erfindung liegt die Aufgabe zugrunde, eine Vorrichtung zur Strommessung zu entwickeln, die eine kleine Baugrösse aufweist, robust gegenüber Montagetoleranzen, äusseren Störfeldern und Temperaturänderungen ist, eine hohe Bandbreite aufweist und eine einfache und kostengünstige Montage ermöglicht.

Die Erfindung besteht in den im Anspruch 1 angegebenen Merkmalen. Vorteilhafte Ausgestaltungen ergeben sich aus den abhängigen Ansprüchen.

Eine Vorrichtung zur Strommessung gemäss der Erfindung ist eine Baugruppe, die aus einem Leiterblech und einem Messelement besteht. Das Messelement besteht aus einem Gehäuse mit elektrischen Anschlüssen. In das Gehäuse ist ein Halbleiterchip mit magnetfeldempfindlichen Sensorelementen eingebettet. Das Leiterblech ist mit drei Ausnehmungen versehen. Die erste und dritte Ausnehmung gehen von einem ersten Seitenrand des Leiterblechs aus. Die zweite Ausnehmung geht von einem gegenüberliegenden zweiten Seitenrand des Leiterblechs aus und ist zwischen der ersten und dritten Ausnehmung angeordnet. Durch die Ausnehmungen ist im Leiterblech ein erster und ein zweiter Leiterabschnitt gebildet, wobei die Stromrichtung im zweiten Leiterabschnitt entgegengesetzt (antiparallel) zur Stromrichtung im ersten Leiterabschnitt verläuft. Die magnetfeldempfindlichen Sensorelemente bilden zwei Magnetfeldsensoren. Die beiden Magnetfeldsensoren sind empfindlich auf eine Komponente des Magnetfelds, die parallel zur Oberfläche des Leiterblechs (und auch parallel zur aktiven Oberfläche des Halbleiterchips) und senkrecht zur Stromrichtung im ersten Leiterabschnitt verläuft. Das Messelement ist im Bereich der zweiten Ausnehmung auf dem Leiterblech platziert und zwar derart, dass sich der erste Magnetfeldsensor über dem ersten Leiterabschnitt und der zweite Magnetfeldsensor über dem zweiten Leiterabschnitt befindet. Der Strom, der durch den ersten Leiterabschnitt fliesst, erzeugt am Ort des ersten Magnetfeldsensors ein Magnetfeld, das im wesentlichen parallel zur Oberfläche des Leiterblechs und senkrecht zur Stromrichtung verläuft. Der Strom, der durch den zweiten Leiterabschnitt fliesst, erzeugt am Ort des zweiten Magnetfeldsensors ein Magnetfeld, das ebenfalls im wesentlichen parallel zur Oberfläche des Leiterblechs und senkrecht zur Stromrichtung verläuft. Die Richtung des Magnetfelds am Ort des ersten Magnetfeldsensors verläuft umgekehrt zur Richtung des Magnetfelds am Ort des zweiten Magnetfeldsensors, weil der Strom im zweiten Leiterabschnitt in die entgegengesetzte Richtung wie der Strom im ersten Leiterabschnitt fliesst. Die beiden Magnetfeldsensoren sind als Differenzsensor geschaltet, so dass sich deren Nutzsignale addieren.

Bei einem bevorzugten Ausführungsbeispiel umfassen die magnetfeldempfindlichen Sensorelemente auf der aktiven Oberfläche des Halbleiterchips angeordnete Magnetfeldkonzentratoren und in die aktive Oberfläche des Halbleiterchips integrierte Hallelemente. Die Magnetfeldkonzentratoren dienen für die Verstärkung und Konzentration der zu messenden Komponente des Magnetfelds am Ort der Hallelemente.

Die Magnetfeldkonzentratoren lenken das Magnetfeld lokal um 90° um. Der im Leiterblech fliessende Strom erzeugt beispielsweise ein Magnetfeld, das im Bereich des ersten Magnetfeldsensors annähernd in die x-Richtung zeigt. Die Magnetfeldkonzentratoren lenken dieses Magnetfeld lokal um 90° um, so dass es an gewissen Stellen ihres Randes in die z-Richtung zeigt, wobei x und z die Achsen eines kartesischen Koordinatensystems bezeichnen. Das Hallelement ist entweder ein horizontales Hallelement, das unterhalb des Randes des Magnetfeldkonzentrators angeordnet ist, oder ein vertikales Hallelement, das seitlich versetzt neben dem Rand des Magnetfeldkonzentrators angeordnet ist, wo die umgelenkten Feldlinien bereits wieder in x-Richtung verlaufen. Die Begriffe "horizontales Hallelement" und "vertikales Hallelement" werden wie in der einschlägigen Literatur üblich verwendet: Vertikale Hallelemente weisen mindestens drei, in der Regel aber vier oder fünf elektrische Kontakte auf, die entlang einer Geraden angeordnet sind. Solche vertikale Hallelemente sind beispielsweise aus der EP 148330 oder der EP 362493 bekannt. Horizontale Hallelemente sind empfindlich auf die Komponente des Magnetfeldes, die senkrecht auf ihre aktive Oberfläche auftrifft, während vertikale Hallelemente empfindlich sind auf die Komponente des Magnetfeldes, die parallel zu ihrer aktiven Oberfläche und senkrecht zur Geraden mit den Kontakten verläuft.

Hallelemente zeigen einen Offset, der sich trotz verschwindendem Magnetfeld als von Null verschiedene Hallspannung manifestiert. Um den Offset zu reduzieren, sind verschiedene Lösungen bekannt geworden, wie insbesondere die Kombination mehrerer Hallelemente, bei denen die Speiseströme in verschiedenen Richtungen fliessen, oder die sogenannte Spinning Current Methode, bei der die Strom- und Spannungskontakte des Hallelements zyklisch vertauscht werden, sowie auch die Kombination beider Lösungen. Unter dem Begriff "Hallelement" ist auch eine solche Kombination von mehreren Hallelementen zu verstehen.

Bei einigen Anwendungen kommt es vor, dass der Strom kurzzeitig auf weit über 100A ansteigt, beispielsweise auf 1000A, 1500A oder sogar 2000A, wobei diese Werte ausserhalb des Arbeitsbereichs liegen. Ursache eines solchen Stromstosses kann beispielsweise ein Kurzschluss sein. Für solche Anwendungen, bei denen die Strommessung in einem vorgegebenen Arbeitsbereich mit einer vorbestimmten Genauigkeit erfolgen muss und in einem vorgegebenen Überlastbereich mit geringerer Genauigkeit erfolgen kann, eignet sich eine Lösung, bei der entweder das in den Magnetfeldsensoren verwendete Hallelement ein vertikales Hallelement ist oder ein zusätzliches vertikales Hallelement vorhanden ist, weil das Ausgangssignal eines Magnetfeldsensors mit einem horizontalen Hallelement oberhalb eines vorgegebenen Grenzstroms konstant ist. Der Grund dafür ist, dass die Magnetfeldkonzentratoren bei Erreichen des Grenzstroms magnetisch gesättigt sind, so dass der durch das horizontale Hallelement gelenkte Magnetfeldfluss bei zunehmendem Strom nicht weiter ansteigt.

Bei einem weiteren Ausführungsbeispiel sind die magnetfeldempfindlichen Sensorelemente AMR (anisotropic magnetic resistance) oder GMR (giant magnetic resistance) Sensoren oder Fluxgate Sensoren. AMR Sensoren, GMR Sensoren wie auch Fluxgate Sensoren enthalten ferromagnetische Materialien. Diese ferromagnetischen Materialien verstärken und konzentrieren die zu messende Komponente des vom Strom erzeugten Magnetfelds, d.h. sie übernehmen auch die Funktion der Magnetfeldkonzentratoren des vorhergehenden Ausführungsbeispiels.

Bei einem weiteren Ausführungsbeispiel sind die magnetfeldempfindlichen Sensorelemente vertikale Hallelemente, die in die aktive Oberfläche des Halbleiterchips integriert sind. Die vertikalen Hallelemente messen direkt die parallel zur aktiven Oberfläche des Halbleiterchips verlaufende Komponente des Magnetfelds.

Die erfindungsgemässe Baugruppe zur Strommessung bietet mehrere Vorteile:
- Sie besteht aus nur zwei Einzelteilen, nämlich aus dem Leiterblech und dem Messelement.
- Das Messelement ist sehr klein. Der Abstand zwischen den beiden Magnetfeldsensoren liegt im Bereich von etwa 1 bis 3 Millimetern. Die Empfindlichkeit des Messelements gegenüber einem äusseren inhomogenen Magnetfeld wird dadurch reduziert.
- Die Montage des Messelements auf dem Leiterblech ist sehr einfach. Es wird einfach an der richtigen Stelle auf das Leiterblech geklebt. Die Positioniergenauigkeit ist nicht sehr kritisch.
- Die Dicke des Leiterblechs kann dem Arbeitsbereich angepasst werden, sie spielt für die Messung keine wesentliche Rolle.
- Durch die Realisierung der gesamten elektronischen Schaltung und aller magnetfeldempfindlichen Sensorelemente auf einem einzigen Halbleiterchip wird die Streuung der Eigenschaften der magnetfeldempfindlichen Sensorelemente reduziert, die magnetfeldempfindlichen Sensorelemente haben immer annähernd die gleiche Temperatur und der Abstand zwischen den beiden Magnetfeldsensoren ist fest vorgegeben und bleibt über die Lebensdauer konstant.

Die erfindungsgemässe Baugruppe eignet sich sehr gut zur Strommessung in elektronischen Hybrid Fahrzeugen (HEV), wo ein bürstenloser Gleichstrommotor (BLDC Motor) von einem hochfrequenten Strom angesteuert wird und Ströme von typisch 200 bis maximal 1000 A zu messen sind. Die Strom-Signale sind pulsbreitenmoduliert und erfordern deshalb eine hohe Bandbreite des Stromsensors bzw. eine Antwortzeit (Response time) im Bereich von 5-20 Mikrosekunden.

Die Erfindung wird nachfolgend anhand von Ausführungsbeispielen und anhand der Zeichnung näher erläutert. Die Figuren sind nicht massstäblich gezeichnet. In den Figuren sind die drei kartesischen Koordinatenrichtungen mit x, y und z bezeichnet.
- Fig. 1: zeigt eine schematische dreidimensionale Darstellung einer erfindungsgemässen Baugruppe zur Strommessung,
- Fig. 2: zeigt einen Magnetfeldsensor in seitlicher Ansicht,
- Fig. 3: zeigt den Magnetfeldsensor in Aufsicht,
- Fig. 4, 5, 6: zeigen weitere Magnetfeldsensoren in seitlicher Ansicht,
- Fig. 7, 8: zeigen Magnetfeldkonzentratoren in Aufsicht,
- Fig. 9, 10: zeigen weitere Ausführungsformen der erfindungsgemässen Baugruppe zur Strommessung, und
- Fig. 11: zeigt ein Diagramm und eine weitere Ausführungsform der erfindungsgemässen Baugruppe zur Strommessung.

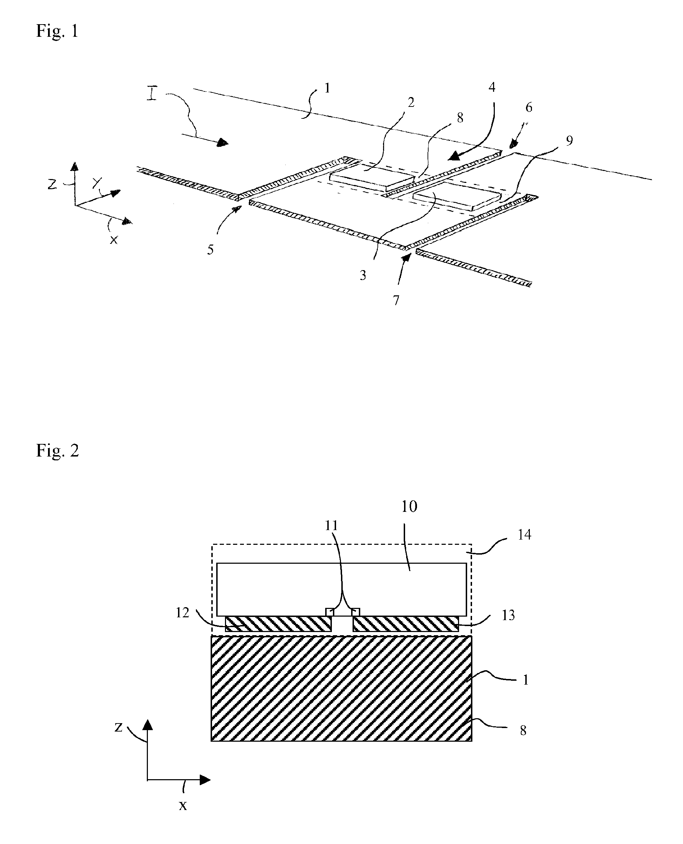

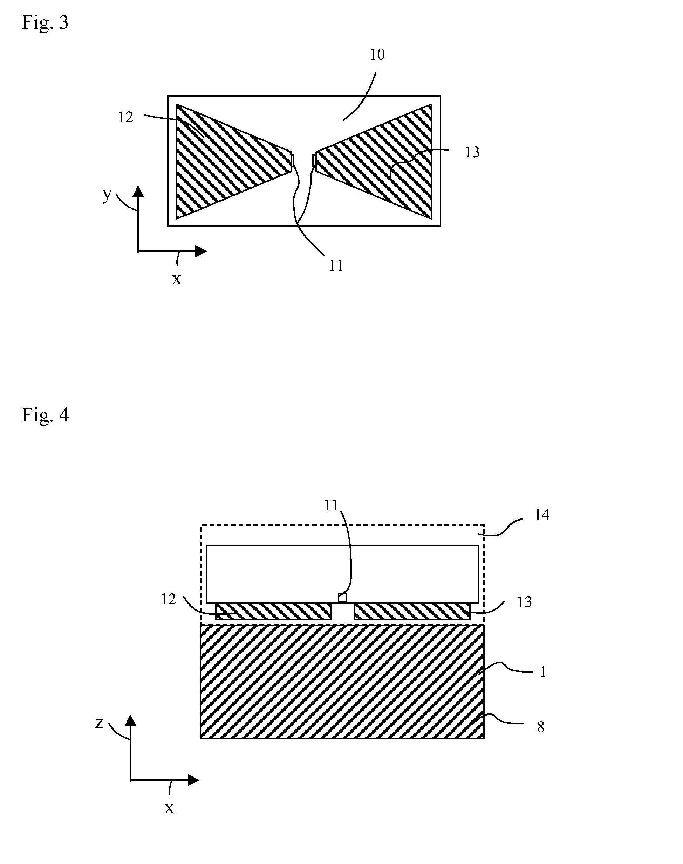

Die Fig. 1 zeigt eine schematische dreidimensionale Darstellung einer erfindungsgemässen Baugruppe zur Strommessung, die beispielsweise für einen Arbeitsbereich von 0 bis 200 A ausgelegt ist. Die Baugruppe umfasst ein Leiterblech 1 in der Form eines Flachleiters, durch das der zu messende Strom I fliesst, und einen aus zwei Magnetfeldsensoren 2 und 3 gebildeten Differenzsensor 4. Das Leiterblech 1 enthält drei orthogonal zu seiner Längsrichtung, hier der x-Richtung, angeordnete Ausnehmungen 5, 6 und 7, so dass ein erster und ein zweiter Leiterabschnitt 8 und 9 derart gebildet sind, dass die Stromrichtung im zweiten Leiterabschnitt 9 entgegengesetzt zur Stromrichtung im ersten Leiterabschnitt 8 verläuft. Die Grenzen der beiden Leiterabschnitte 8 und 9 sind durch gestrichelte Linien illustriert. Der erste Magnetfeldsensor 2 ist auf dem ersten Leiterabschnitt 8 und der zweite Magnetfeldsensor 3 ist auf dem zweiten Leiterabschnitt 9 angeordnet. Die beiden Magnetfeldsensoren 2 und 3 sind empfindlich auf eine Komponente des Magnetfelds, die parallel zur Oberfläche des Leiterblechs 1 und orthogonal zur Stromrichtung im ersten (bzw. auch zweiten) Leiterabschnitt 8 verläuft. Im Beispiel sind die beiden Magnetfeldsensoren 2 und 3 somit empfindlich auf die x-Komponente des Magnetfelds. Die beiden Magnetfeldsensoren 2 und 3 sind im Prinzip identisch. Die beiden Magnetfeldsensoren werden anhand der Fig. 2 und 3 näher erläutert. Die Baugruppe umfasst weiter eine elektronische Schaltung für den Betrieb des Differenzsensors 4.

Aus Gründen der zeichnerischen Klarheit ist in der Fig. 1 ein wichtiger Aspekt der Erfindung nicht dargestellt, nämlich dass die beiden Magnetfeldsensoren 2 und 3 in einem gemeinsamen Halbleiterchip integriert und in ein gemeinsames Gehäuse eingebettet sind. Die erfindungsgemässe Baugruppe zur Strommessung besteht somit aus nur zwei Einzelteilen, nämlich dem Leiterblech 1 und einem Messelement, das an einer vorgesehenen Position auf dem Leiterblech 1 montiert wird. Das Messelement enthält einen in herkömmlicher Technologie in einem Gehäuse eingebetteten Halbleiterchip mit magnetfeldempfindlichen Sensorelementen. Die aktive Oberfläche des Halbleiterchips verläuft parallel zur Oberfläche des Leiterblechs 1, auf der das Messelement befestigt ist. Die magnetfeldempfindlichen Sensorelemente bilden die beiden Magnetfeldsensoren 2 und 3. Der Halbleiterchip enthält mit Vorteil auch die elektronische Schaltung, die die beiden Magnetfeldsensoren 2 und 3 als Differenzsensor betreibt, so dass ihr Ausgangssignal proportional zur Stärke des durch das Leiterblech 1 fliessenden Stroms I ist.

Die magnetfeldempfindlichen Sensorelemente sind zum Beispiel AMR oder GMR oder Fluxgate Sensoren. Die magnetfeldempfindlichen Sensorelemente sind jedoch bevorzugt Hallelemente oder eine Kombination aus Hallelementen und Magnetfeldkonzentratoren. Die Hallelemente sind in die aktive Oberfläche des Halbleiterchips integriert. Die Magnetfeldkonzentratoren sind auf der aktiven Oberfläche des Halbleiterchips angeordnet. Wie in der Einleitung erwähnt, unterscheidet man zwischen horizontalen und vertikalen Hallelementen. Ein vertikales Hallelement misst eine parallel zur aktiven Oberfläche des Halbleiterchips gerichtete Komponente des Magnetfelds. Es ist also so auszurichten, dass es die x-Komponente misst. Ein horizontales Hallelement misst die senkrecht zur aktiven Oberfläche des Halbleiterchips gerichtete Komponente des Magnetfelds, das ist hier ein in z-Richtung verlaufendes Magnetfeld. Das horizontale Hallelement ist deshalb im Bereich des Randes eines Magnetfeldkonzentrators anzuordnen, der die Aufgabe hat, das zu messende, in x-Richtung gerichtete Magnetfeld lokal um 90° zu drehen, so dass es am Ort des horizontalen Hallelements in z-Richtung verläuft.

Anhand der Fig. 2 bis 6 werden verschiedene Beispiele präsentiert, die eine Vielfalt an Möglichkeiten illustrieren, wie ein aus mindestens einem Hallelement und mindestens einem Magnetfeldkonzentrator gebildeter Magnetfeldsensor aufgebaut sein kann. Dabei ist nur der oberhalb des ersten Leiterabschnitt 8 angeordnete Magnetfeldsensor 2 dargestellt, obwohl der oberhalb des zweiten Leiterabschnitts 9 angeordnete Magnetfeldsensor 3 in gleicher Weise auf dem gleichen Halbleiterchip realisiert ist und im gleichen Gehäuse eingebettet ist.

Die Fig. 2 und 3 zeigen den Magnetfeldsensor 2 in seitlicher Ansicht (gemäss der Fig. 1 in y-Richtung) und in Aufsicht (gemäss der Fig. 1 in negativer z-Richtung). Der Magnetfeldsensor 2 enthält mindestens ein in einem Halbleiterchip 10 integriertes Hallelement 11 und zwei durch einen Luftspalt getrennte, auf dem Halbleiterchip 10 angebrachte Magnetfeldkonzentratoren 12 und 13. Der Magnetfeldsensor 2 ist wie ein herkömmlicher IC im Gehäuse 14 verkapselt. In der Fig. 2 ist auch der Leiterabschnitt 8 des Leiterblechs 1 dargestellt. Das Hallelement 11 ist im Bereich zwischen den beiden Magnetfeldkonzentratoren 12 und 13 in den Halbleiterchip 10 integriert. Das Hallelement 11 kann ein horizontales Hallelement sein, das empfindlich ist auf die senkrecht zur aktiven Oberfläche des Halbleiterchips 10 verlaufende Magnetfeldkomponente, d.h. hier die z-Komponente, oder es kann ein vertikales Hallelement sein, das empfindlich ist auf die parallel zur aktiven Oberfläche des Halbleiterchips 10 verlaufende Magnetfeldkomponente, d.h. hier die x-Komponente. Das Hallelement wird von Feldlinien des Streufelds durchflutet, das sind Feldlinien, die ausserhalb des Luftspalts vom ersten Magnetfeldkonzentrator 12 zum zweiten Magnetfeldkonzentrator 13 verlaufen. Diese Feldlinien verlaufen senkrecht zur Oberfläche der Magnetfeldkonzentratoren 12 und 13. Ein horizontales Hallelement ist unterhalb des Randes des Magnetfeldkonzentrators 12 bzw. 13 auf der dem Luftspalt abgewandten Seite des Randes anzuordnen, wo möglichst viele Feldlinien des Streufelds in z-Richtung verlaufen, während ein vertikales Hallelement neben dem Rand des Magnetfeldkonzentrators 12 bzw. 13 im Luftspalt anzuordnen ist, wo möglichst viele Feldlinien des Streufelds in x-Richtung verlaufen. Wenn als Hallelement 11 ein horizontales Hallelement verwendet wird, dann werden bevorzugt zwei horizontale Hallelemente verwendet, wobei das erste Hallelement beim ersten Magnetfeldkonzentrator 12 und das zweite Hallelement beim zweiten Magnetfeldkonzentrator 13 angeordnet ist, so dass die Feldlinien des Streufelds das eine Hallelement in positiver z-Richtung und das andere Hallelement in negativer z-Richtung durchfluten. Die beiden Hallelemente sind so verdrahtet und werden so betrieben, dass sich ihre Hallspannungen zu einem Nutzsignal addieren. Das Hallelement 11 misst somit die von den beiden Magnetfeldkonzentratoren 12 und 13 verstärkte, in x-Richtung gerichtete Komponente des äusseren Magnetfelds. Die Magnetfeldkonzentratoren 12 und 13 sind bevorzugt auf den Luftspalt hin verjüngt ausgebildet, so dass sie die magnetischen Feldlinien auch in y-Richtung sammeln und im Luftspalt am Ort des Hallelements 11 konzentrieren.

Wie aus der Fig. 1 ersichtlich ist, erstreckt sich das Leiterblech 1 in x-Richtung. Die Ausnehmungen 5, 6 und 7 erstrecken sich in y-Richtung. Die Magnetfeldsensoren 2 und 3 sind so ausgerichtet, dass die Magnetfeldkonzentratoren 12 und 13 die in x-Richtung verlaufende Komponente des Magnetfelds verstärken. Der durch den ersten Leiterabschnitt 8 fliessende Strom erzeugt ein zirkulares Magnetfeld B₁, das von den beiden Magnetfeldkonzentratoren 12 und 13 des ersten Magnetfeldsensors 2 gesammelt, konzentriert und durch das zugehörige Hallelement 11 geleitet wird. Die Feldlinien des Magnetfelds B₁ treten in den Magnetfeldkonzentrator 12 ein und aus dem Magnetfeldkonzentrator 13 wieder aus, d.h. sie verlaufen in positiver x-Richtung. Der durch den zweiten Leiterabschnitt 9 fliessende Strom erzeugt ein zirkulares Magnetfeld B₂ mit zum Magnetfeld B₁ entgegengesetztem Drehsinn, das von den beiden Magnetfeldkonzentratoren 12 und 13 des zweiten Magnetfeldsensors 3 ebenfalls gesammelt, konzentriert und durch das zugehörige Hallelement 11 geleitet wird. Die Feldlinien des Magnetfelds B₂ treten also hier in den Magnetfeldkonzentrator 13 ein und aus dem Magnetfeldkonzentrator 12 wieder aus, d.h. sie verlaufen in negativer x-Richtung. Das Ausgangssignal des Differenzsensors 4 wird deshalb als Differenz der Ausgangssignale der beiden Magnetfeldsensoren 2 und 3 gebildet, das somit proportional zur Differenz der beiden Magnetfelder B₁ und B₂ ist. Der Differenzsensor 4 misst also nur das von dem durch das Leiterblech 1 in den Leiterabschnitten 8 und 9 fliessenden Strom erzeugte Magnetfeld, nicht aber die x-Komponente eines allfälligen äusseren Störfeldes.

Weil die beiden Magnetfeldsensoren 2 und 3 nur das Magnetfeld messen, das vom Strom I im ersten Leiterabschnitt 8 bzw. im zweiten Leiterabschnitt 9 erzeugt wird, können die Ausnehmungen 5, 6 und 7 in x-Richtung beliebig schmal sein. Der ohmsche Widerstand des Leiterblechs 1 wird deshalb durch die Ausnehmungen 5, 6 und 7 nur geringfügig erhöht und auch die entstehende Verlustwärme wird sehr gut abgeführt.

Die Fig. 4 zeigt einen Magnetfeldsensor, bei dem als Hallelement 11 ein vertikales Hallelement verwendet wird, das in der Mitte zwischen den beiden Magnetfeldkonzentratoren 12 und 13 angeordnet ist.

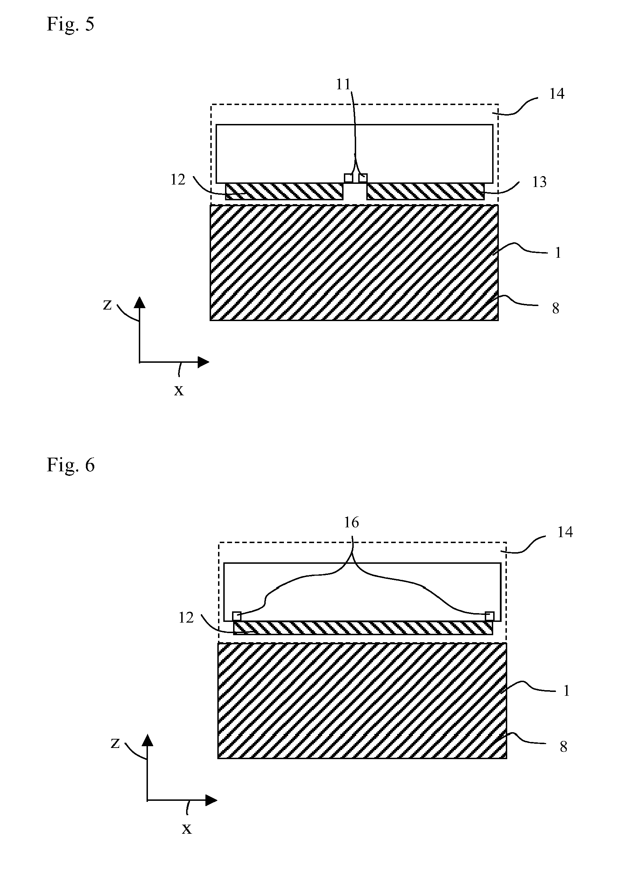

Die Fig. 5 zeigt einen Magnetfeldsensor, bei dem als Hallelement 11 zwei vertikale Hallelemente verwendet werden, die zwischen den beiden Magnetfeldkonzentratoren 12 und 13 angeordnet sind. Das lokale Streufeld durchflutet die beiden vertikalen Hallelemente in gleicher Richtung.

Die Fig. 6 zeigt einen Magnetfeldsensor 2, der nur einen einzigen Magnetfeldkonzentrator 12 und zwei horizontale Hallelemente 16 aufweist, die unterhalb seines Randes angeordnet sind. Die beiden horizontalen Hallelemente 16 werden von magnetischen Feldlinien durchflutet, die beim einen Hallelement in positiver z-Richtung, beim anderen Hallelement in negativer z-Richtung verlaufen. Als Ausgangssignal des Magnetfeldsensors 2 wird die Differenz der Hallspannungen der beiden Hallelemente gebildet, das somit unabhängig von einem äusseren Magnetfeld ist. Anstelle der beiden horizontalen Hallelemente 16 kann auch mindestens ein vertikales Hallelement vorgesehen sein, das allerdings neben dem Rand des Magnetfeldkonzentrators 12 anzuordnen ist.

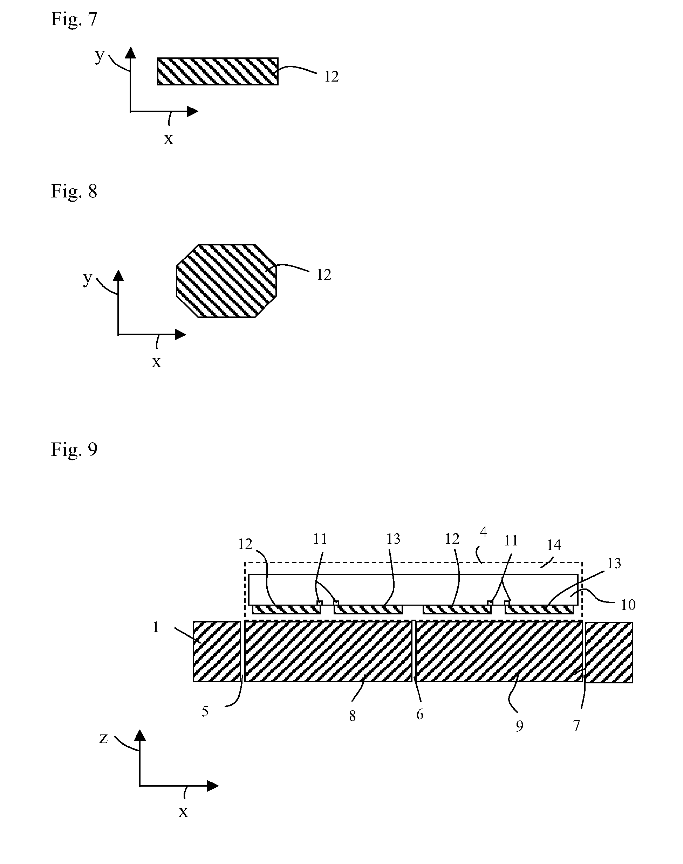

Die Fig. 7 und 8 zeigen in Aufsicht einen Magnetfeldkonzentrator 12 für den Magnetfeldsensor gemäss Fig. 6. Der Magnetfeldkonzentrator 12 ist im einen Fall rechteckförmig, im anderen Fall in der Mitte verbreitert, um in y-Richtung zusätzliche Feldlinien zu sammeln und am Ort des Hallelementes 16 zu konzentrieren.

Die Fig. 9 zeigt ein Ausführungsbeispiel der erfindungsgemässen Baugruppe zur Strommessung in seitlicher Ansicht, bei der jeder der beiden Magnetfeldsensoren 2 und 3 zwei Magnetfeldkonzentratoren 12, 13 umfasst.

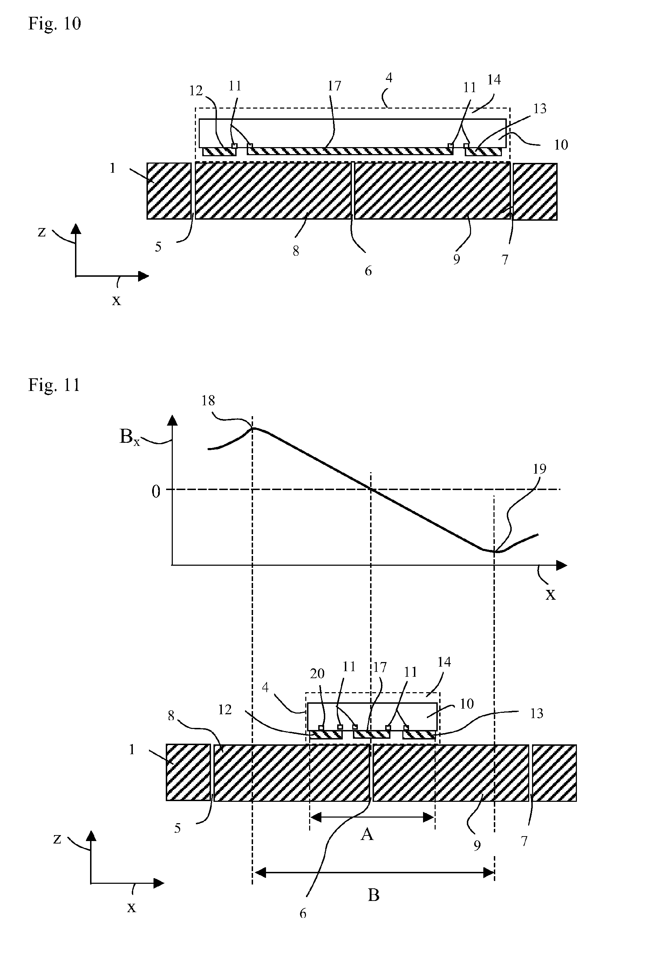

Die Fig. 10 zeigt ein ähnliches Ausführungsbeispiel, bei dem der zweite Magnetfeldkonzentrator des ersten Magnetfeldsensors 2 und der erste Magnetfeldkonzentrator des zweiten Magnetfeldsensors 3 durch einen einzigen Magnetfeldkonzentrator 17 ersetzt sind, d.h. sie sind zu einem einzigen Magnetfeldkonzentrator 17 verbunden.

Die Fig. 11 zeigt ein Diagramm und eine Baugruppe für die Strommessung. Das Diagramm veranschaulicht den Verlauf der x-Komponente Bₓ des Magnetfelds auf der Höhe der Magnetfeldkonzentratoren 12, 13 bzw. 17 über den beiden Leiterabschnitten 8 und 9, aber bei Abwesenheit der Magnetfeldkonzentratoren 12, 13 bzw. 17. Das Magnetfeld wird von dem durch die Leiterabschnitte 8 und 9 fliessenden Strom erzeugt. Die x-Komponente Bₓ ist symmetrisch bezüglich der Mitte der Ausnehmung 6, wo sie das Vorzeichen wechselt, und hat ein positives Extremum 18 und ein negatives Extremum 19. Der Abstand zwischen den beiden Extrema 18 und 19 beträgt B. Zwischen den beiden Extrema 18 und 19 gibt es einen Bereich, wo der Verlauf der x-Komponente Bₓ annähernd linear ist.

Die Baugruppe für die Strommessung der Fig. 11 zeichnet sich dadurch aus, dass die Magnetfeldkonzentratoren 12, 13 bzw. 17 kürzer als bei den vorangehenden Beispielen sind. Die Distanz A zwischen den äusseren Enden der beiden am weitesten voneinander entfernten Magnetfeldkonzentratoren 12 und 13 des Differenzsensors 4 ist etwa gleich gross oder kürzer als die Distanz B. Diese Lösung ist besonders robust gegenüber unvermeidlichen Montagetoleranzen und gegenüber Alterungserscheinungen, die im mehrjährigen Betrieb einer solchen Baugruppe für die Strommessung auftreten können, da Verschiebungen des Differenzsensors 4 in x-Richtung innerhalb vorgegebener Toleranzgrenzen keine oder eine vernachlässigbare Änderung des Ausgangssignals zur Folge haben. Während der Differenzsensor 4 der Fig. 10 ausgelegt ist auf maximale Empfindlichkeit, ist der Differenzsensor 4 der Fig. 11 ausgelegt auf grössere Robustheit gegenüber Montagetoleranzen, aber zulasten der Empfindlichkeit.

Wie in der Einleitung erwähnt, kommt es bei einigen Anwendungen vor, dass der Strom kurzzeitig auf weit über 100A ansteigt, beispielsweise auf 1000A, 1500A oder sogar 2000A. Für solche Anwendungen ist mit Vorteil entweder das in den Magnetfeldsensoren 2 und 3 verwendete Hallelement 11 ein vertikales Hallelement oder es ist ein zusätzliches vertikales Hallelement vorhanden. Beim Beispiel der Fig. 11 sind die Hallelemente 11, die das von den Magnetfeldkonzentratoren 12, 17 und 13 umgelenkte Magnetfeld messen, horizontale Hallelemente. Zusätzlich ist ein vertikales Hallelement 20 vorhanden, das vor allem dann ein Signal liefern muss, wenn das Ausgangssignal der horizontalen Hallelemente mit zunehmendem Strom nicht mehr ansteigt, weil die Magnetfeldkonzentratoren 12, 17 und 13 teilweise oder vollständig magnetisch gesättigt sind. Es genügt, wenn wenigstens einer der beiden Magnetfeldsensoren 2 und 3 ein vertikales Hallelement aufweist. Das vertikale Hallelement 20 kann grundsätzlich überall platziert werden, wo die x-Komponente Bₓ des vom Strom erzeugten Magnetfelds ausreichend gross ist, sei es im Bereich des Randes eines Magnetfeldkonzentrators, wo die umgelenkten Feldlinien bereits wieder annähernd in x-Richtung verlaufen, oder irgendwo unterhalb des Magnetfeldkonzentrators oder sogar irgendwo abseits des Magnetfeldkonzentrators. Der Beitrag des vertikalen Hallelements 20 zum Messsignal ist dann je nach seiner Lage unterschiedlich. Wenn nur ein einziges vertikales Hallelement 20 vorhanden ist, dann erfasst die Messung im Überlastbereich auch eine allfällige x-Komponente eines magnetischen Störfeldes, die aber in der Regel vergleichsweise klein gegenüber dem zu messenden Magnetfeld ist. Um dies auszuschliessen, können natürlich auch zwei vertikale Hallelemente vorhanden sein, wobei das erste vertikale Hallelement im Bereich des ersten Leiterabschnitts 8 und das zweite vertikale Hallelement im Bereich des zweiten Leiterabschnitts 9 angeordnet ist, und wobei die beiden vertikalen Hallelemente als Differenzsensor geschaltet sind.

Bei allen Ausführungsbeispielen verläuft die zu messende Komponente des Magnetfelds parallel zur flachen Oberfläche des Leiterblechs 1 und somit auch parallel zur aktiven Oberfläche des Halbleiterchips 10.

Die oben beschriebenen Ausführungsbeispiele stellen eine bevorzugte Lösung dar, weil alle magnetfeldempfindlichen Sensorelemente auf einem einzigen Halbleiterchip untergebracht sind und dieser Halbleiterchip in einem einzigen Gehäuse verpackt ist. Das Messelement liefert ein Ausgangssignal, das proportional zur Differenz der Ausgangssignale der beiden Magnetfeldsensoren 2 und 3 ist. Diese Lösung ist besonders einfach und daher sehr kostengünstig. Es gibt aber Anwendungen, die zusätzliche Anforderungen stellen, die durch diese Lösung nicht erfüllt werden. Eine solche Anforderung ist, dass das Messelement eine gewisse Redundanz aufweist, damit auch bei Störfällen noch ein Messsignal geliefert wird. So kann z.B. eine Anforderung darin bestehen, dass die beiden Magnetfeldsensoren 2 und 3 galvanisch getrennt sind. Um diese Anforderungen zu erfüllen, gibt es zwei alternative Möglichkeiten:
1. Die beiden Magnetfeldsensoren 2 und 3 sind auf zwei getrennten Halbleiterchips realisiert, die aber in das gleiche Gehäuse eingebettet sind. Die Ausgangssignale der beiden Magnetfeldsensoren werden über zwei Anschlüsse nach aussen geliefert und von einer Interfaceschaltung weiterverarbeitet.
2. Die beiden Magnetfeldsensoren 2 und 3 sind auf zwei getrennten Halbleiterchips realisiert, die ihrerseits in ein separates Gehäuse verpackt sind, z.B. ein SO-8, SO-16, SOIC, DIL oder anderes Standardgehäuse. Die beiden Gehäuse sind auf einer Leiterplatte oder einem anderen Träger montiert und bilden so das Messelement.

Bei diesen Lösungen kann der Abstand zwischen den beiden Magnetfeldsensoren auch etwas grösser sein und bis zu 10 Millimeter betragen.

Es wurden Ausführungsbeispiele und Anwendungen dieser Erfindung dargestellt und beschrieben. Es ist für Fachleute nach dem Studium dieser Patentanmeldung klar, dass viele weitere Modifikationen möglich sind ohne vom erfinderischen Konzept abzuweichen.

## Patentansprüche

1. Baugruppe zur Strommessung, bestehend aus
einem Leiterblech (1), das mit drei Ausnehmungen (5, 6, 7) versehen ist, wobei die erste und dritte Ausnehmung (5, 7) von einem ersten Seitenrand des Leiterblechs (1) ausgehen und wobei die zweite Ausnehmung (6) von einem gegenüberliegenden zweiten Seitenrand des Leiterblechs (1) ausgeht und zwischen der ersten und dritten Ausnehmung (5, 7) angeordnet ist, so dass im Leiterblech (1) ein erster und ein zweiter Leiterabschnitt (8, 9) gebildet sind, wobei die Stromrichtung im zweiten Leiterabschnitt (9) entgegengesetzt zur Stromrichtung im ersten Leiterabschnitt (8) verläuft, und
einem Messelement mit zwei Magnetfeldsensoren (2, 3), die empfindlich sind auf eine Komponente des Magnetfelds, die parallel zur Oberfläche des Leiterblechs (1) und senkrecht zur Stromrichtung im ersten Leiterabschnitt (8) verläuft, wobei das Messelement auf dem Leiterblech (1) platziert ist und zwar derart, dass sich der erste Magnetfeldsensor (2) über dem ersten Leiterabschnitt (8) und der zweite Magnetfeldsensor (3) über dem zweiten Leiterabschnitt (9) befindet, und wobei die Magnetfeldsensoren (2, 3) aus magnetfeldempfindlichen Sensorelementen gebildet sind, die auf mindestens einem Halbleiterchip (10) realisiert sind.

2. Baugruppe nach Anspruch 1, **dadurch gekennzeichnet, dass** die magnetfeldempfindlichen Sensorelemente auf der aktiven Oberfläche des mindestens einen Halbleiterchips (10) angeordnete Magnetfeldkonzentratoren (12, 13) und in die aktive Oberfläche des mindestens einen Halbleiterchips (10) integrierte Hallelemente (11; 16) umfassen, wobei die Magnetfeldkonzentratoren (12, 13) für die Verstärkung und Konzentration der genannten Komponente des Magnetfelds am Ort der Hallelemente (11;16) dienen.

3. Baugruppe nach Anspruch 2, **dadurch gekennzeichnet, dass** der mindestens eine Halbleiterchip (10) ein einziger Halbleiterchip ist, dass die Anzahl der Magnetfeldkonzentratoren (12, 13, 17) drei beträgt, dass die drei Magnetfeldkonzentratoren entlang einer Linie angeordnet sind, und dass der mittlere Magnetfeldkonzentrator ein für beide Magnetfeldsensoren (2, 3) gemeinsamer Magnetfeldkonzentrator (17) ist.

4. Baugruppe nach Anspruch 2 oder 3, wobei der durch das Leiterblech (1) fliessende Strom ein Magnetfeld erzeugt, dessen genannte, parallel zur Oberfläche des Leiterblechs (1) und senkrecht zur Stromrichtung im ersten Leiterabschnitt (8) gerichtete Komponente bei Abwesenheit der Magnetfeldkonzentratoren (12, 13) zwei Extrema aufweist, die im Abstand B zueinander liegen, **dadurch gekennzeichnet, dass** die Distanz (A) zwischen den äusseren Enden der beiden am weitesten voneinander entfernten Magnetfeldkonzentratoren (12, 13) des Messelements gleich gross oder kürzer als die Distanz B ist.

5. Baugruppe nach Anspruch 1, **dadurch gekennzeichnet, dass** die magnetfeldempfindlichen Sensorelemente in eine aktive Oberfläche des mindestens einen Halbleiterchips (10) integrierte vertikale Hallelemente (11; 16) sind.

6. Baugruppe nach Anspruch 1, **dadurch gekennzeichnet, dass** die magnetfeldempfindlichen Sensorelemente AMR oder GMR oder Fluxgate Sensoren sind.

7. Messelement für eine Baugruppe zur Strommessung nach Anspruch 1, mit zwei Magnetfeldsensoren (2, 3), die aus magnetfeldempfindlichen Sensorelementen gebildet sind, die auf mindestens einem Halbleiterchip (10) realisiert sind, wobei beide Magnetfeldsensoren (2, 3) empfindlich sind auf eine Komponente des Magnetfelds, die parallel zur Oberfläche des mindestens einen Halbleiterchips (10) verläuft.
